# EUROPEAN PATENT APPLICATION

(11) **EP 4 517 806 A2**
(43) Date of publication of application: **05.03.2025**
(21) Application number: 24198057.2
(22) Date of filing: 03.09.2024
(51) Int. Cl.: H01L 23/00, H01L 23/373, H01L 23/433

(54) **POWER MODULE AND POWER CONVERSION APPARATUS**

(30) Priority: 04.09.2023 CN 202311138958
(71) Applicant: Huawei Digital Power Technologies Co., Ltd., Shenzhen, Guangdong 518043 (CN)
(72) Inventor: LI, Hui, Shenzhen, 518043 (CN); ZHOU, Sizhan, Shenzhen, 518043 (CN); WANG, Zhaoyue, Shenzhen, 518043 (CN); CHEN, Huibin, Shenzhen, 518043 (CN); ZHAO, Huaibin, Shenzhen, 518043 (CN); WANG, Junhe, Shenzhen, 518043 (CN); LV, Yafei, Shenzhen, 518043 (CN)
(74) Representative: Gill Jennings & Every LLP

(57) **Abstract**

Embodiments of this application provide a power module and a power conversion apparatus. The power module includes: a first metal brazed substrate; a chipset disposed on the first metal brazed substrate, where the chipset includes at least two chips; and a clip, where the clip covers a side, away from the first metal brazed substrate, of the chipset. Each connecting unit is electrically connected to a corresponding chip. Every two adjacent connecting units are connected along a first direction through a body. Each connecting arm is arranged with respect to two adjacent chips in the chipset. The connecting arm is connected to the first metal brazed substrate. A shortest distance between the connecting arm and one of the two adjacent chips is a first shortest distance, and a shortest distance between the connecting arm and the other of the two adjacent chips is a second shortest distance. A difference between the first shortest distance and the second shortest distance falls within a preset threshold. This helps balance current paths of the chips and reduce a difference between parasitic parameters of the chips, and therefore further improves a dynamic current equalization characteristic of parallel chips.

## Description

### TECHNICAL FIELD

This application relates to the field of semiconductor technologies, and in particular, to a power module and a power conversion apparatus.

### BACKGROUND

With development of power electronic technologies, a power module has attracted increasing attention. An electrical connection of a semiconductor chip in the power module is mainly implemented by using an aluminum wire welding technology. An electrode of the semiconductor chip is connected to a metal layer on a surface of a substrate through an aluminum wire. However, when a large quantity of chips are arranged in the power module, a quantity of aluminum wires also increases correspondingly. A large quantity of aluminum wires leads to an increase of parasitic inductance of the power module. In addition, when a plurality of chips are connected in parallel, a plurality of aluminum wires are used for connection. This leads to uneven currents between the plurality of chips connected in parallel. The uneven currents lead to uneven heat generation by the chips connected in parallel. Severe local heat generation affects performance of the chips, and therefore affects performance of the power module.

### SUMMARY

Embodiments of this application provide a power module and a power conversion apparatus that can help reduce parasitic inductance and improve current equalization.

According to a first aspect, an embodiment of this application provides a power module. The power module includes:
a first metal brazed substrate;
a chipset disposed on the first metal brazed substrate, where the chipset includes at least two chips arranged in a straight line along a first direction, and the first direction is parallel to a plane on which a side, away from the first metal brazed substrate, of the chips is located; and
a clip, where the clip covers a side, away from the first metal brazed substrate, of the chipset, the clip includes a body, at least two connecting units, and at least one connecting arm, each connecting unit is electrically connected to a corresponding chip, every two adjacent connecting units are connected along the first direction through the body, each connecting arm is arranged with respect to two adjacent chips in the chipset, the connecting arm is connected to the first metal brazed substrate, a shortest distance between the connecting arm and one of the two adjacent chips in the chipset is a first shortest distance, a shortest distance between the connecting arm and the other of the two adjacent chips is a second shortest distance, and a difference between the first shortest distance and the second shortest distance is not greater than 30% of the first shortest distance.

The chips in the chipset are connected in parallel through the clip. The clip is wider than a commonly used aluminum wire, and has a larger flow path. This helps enhance connection between a plurality of chips and improve consistency between parasitic parameters of parallel chips, and therefore optimizes dynamic current equalization between a plurality of parallel chips.

Contact between an aluminum wire and a chip is point contact, and the aluminum wire is very likely to be detached from the chip. However, in this application, contact between the clip and the chips is surface contact, so that strength of connection between the clip and the chips is improved. This enhances structural reliability between a plurality of chips and ensures stability of current transmission. In addition, the chips in the chipset are arranged in a straight line along the first direction, and the clip covers the side, away from the first metal brazed substrate, of the chipset. In this way, two adjacent chips are connected through a shortest straight path. The clip and the chip are in surface contact. This also helps improve a transient heat dissipation capability of the power module.

Each connecting unit is electrically connected to a corresponding chip, and every two adjacent connecting units are connected along the first direction through the body. To be specific, two adjacent chips are connected through the body with a shortest straight path. A plurality of parallel chips in the chipset are connected through the clip with a shortest straight path, to reduce interconnection parasitic inductance between the chips.

Each connecting arm is arranged with respect to two adjacent chips in the chipset. A shortest distance between the connecting arm and one chip is a first shortest distance, and a shortest distance between the connecting arm and the other chip is a second shortest distance. A difference between the first shortest distance and the second shortest distance is not greater than 30% of the first shortest distance. One of two adjacent chips, the clip, and the first metal brazed substrate form a first interconnection path, and the other chip, the clip, and the first metal brazed substrate form a second interconnection path. The first interconnection path and the second interconnection path are approximately symmetric. This helps balance current paths of the chips and reduce a difference between parasitic parameters of the chips, and therefore further improves a dynamic current equalization characteristic of parallel chips.

According to the first aspect, in a possible implementation, each chip includes a first source and a second source that are arranged along the first direction, a first source of one of two adjacent chips in the chipset and a second source of the other chip are arranged adjacently, the connecting unit is electrically connected to both a first source and a second source of a corresponding chip, and the connecting arm is convexly disposed on the body and bends and extends toward the first metal brazed substrate, so that the connecting arm extends to a position for pre-connection to the first metal brazed substrate.

In a possible implementation, a joint between the connecting arm and the first metal brazed substrate is located on a middle line of a shortest connection line between the two adjacent chips, and the first shortest distance and the second shortest distance may be considered to be the same.

According to the first aspect, in a possible implementation, the chip further includes a gate wire, the first source, the gate wire, and the second source are arranged along the first direction, each connecting unit further includes a first contact portion, an avoidance space, and a second contact portion that are sequentially arranged along the first direction, the first contact portion is in contact with the first source, the second contact portion is in contact with the second source, the avoidance space has an avoidance opening arranged toward the gate wire, and a position of the avoidance opening is arranged with respect to a position of the gate wire.

The chip has a quite small size, and the gate wire is likely to be damaged due to stress, leading to failure of the chip. In this possible implementation, the position of the avoidance opening of the avoidance space is arranged with respect to the position of the gate wire. In this way, the clip is disposed away from the gate wire, so that stress applied by the clip to the gate wire is reduced. This helps reduce a possibility that the gate wire is damaged, and extends cycle life of the power module.

According to the first aspect, in a possible implementation, at least two connecting holes are formed on the body, each connecting unit is disposed in a corresponding connecting hole, the first contact portion is connected to a hole wall of the connecting hole, and the second contact portion is connected to a hole wall of the connecting hole.

According to the first aspect, in a possible implementation, the body and the first metal brazed substrate are spaced apart. At least one of the first contact portion and the second contact portion in each connecting unit is connected to the body. The first contact portion connected to the body and the second contact portion connected to the body each include a connecting section and a contact section. At least a part of the connecting section bends relative to the body. The connecting section is connected between the body and the contact section. A contact section of the first contact portion is in contact with a corresponding first source. A contact section of the second contact portion is in contact with a corresponding second source.

In this possible implementation, the bent section bends relative to the body, and the contact section is connected to the body through the bent section, so that the body is above and away from the chip. This improves layout flexibility for the power module.

According to the first aspect, in a possible implementation, the power module further includes a plastic package body. The plastic package body is wrapped around the first metal brazed substrate, the chipset, and the clip. A first locking hole is provided at a joint between the connecting section and the body, and the first locking hole is filled with the plastic package body.

The plastic package body is subject to delamination at a bent position of a mechanical part or in a continuous large-area planar region of a mechanical part. This affects sealing performance of the power module. In this possible implementation, the first locking hole is provided at the joint between the connecting section and the body, and the first locking hole is filled with the plastic package body, so that a possibility that the plastic package body is delaminated at the joint between the body and the connecting section is reduced, and/or a possibility that the plastic package body is delaminated and spreads to a surface of the chip is reduced. This helps improve sealing performance of the power module.

According to the first aspect, in a possible implementation, the power module further includes a plastic package body. The plastic package body is wrapped around the first metal brazed substrate, the chipset, and the clip. The body is provided with a second locking hole, and the second locking hole is filled with the plastic package body.

The plastic package body is subject to delamination at a bent position of a mechanical part or in a continuous large-area planar region of a mechanical part. This affects sealing performance of the power module. In this possible implementation, the body is provided with the second locking hole, and the second locking hole is filled with the plastic package body, so that a possibility that the plastic package body is delaminated on the body is reduced, or a possibility that the plastic package body is delaminated and spreads to a surface of the chip is reduced. This helps improve sealing performance of the power module.

According to the first aspect, in a possible implementation, a first contact portion and a second contact portion in at least one connecting unit are arranged at a spacing along the first direction, the avoidance space is a groove that passes through the clip along a second direction, and the second direction is perpendicular to the plane on which the side, away from the first metal brazed substrate, of the chips is located.

In this possible implementation, the avoidance space is a groove that passes through the clip along the second direction. This further reduces stress applied by the clip to the gate wire.

According to the first aspect, in a possible implementation, the at least one connecting unit further includes a bent portion, the bent portion is connected between the first contact portion and the second contact portion along the first direction, the bent portion protrudes along a direction away from the first metal brazed substrate, and the first contact portion, the bent portion, and the second contact portion enclose the avoidance space.

In this possible implementation, the first contact portion is fastened to the second contact portion through the bent portion. This helps enhance strength of the clip.

According to the first aspect, in a possible implementation, the bent portion is provided with a buffer hole that passes through the bent portion along the second direction, and the second direction is perpendicular to the plane on which the side, away from the first metal brazed substrate, of the chips is located.

In this possible implementation, the buffer hole is configured to reduce and buffer stress applied by the clip to the chip. This helps reduce a possibility that the chip is damaged due to the stress applied by the clip, and extends cycle life of the power module.

According to the first aspect, in a possible implementation, the first metal brazed substrate includes a first insulation substrate and a mounting metal layer covering the first insulation substrate, and the chipset is disposed on a side, away from the first insulation substrate, of the mounting metal layer. There are a plurality of mounting metal layers. The plurality of mounting metal layers are arranged on the first insulation substrate at spacings. The plurality of mounting metal layers include a first mounting metal layer, a second mounting metal layer, a third mounting metal layer, and a fourth mounting metal layer. The second mounting metal layer includes a first extension portion, a groove, and a second extension portion. An end of the first extension portion is connected to an end of the second extension portion. The first mounting metal layer, the first extension portion, the groove, the second extension portion, and the third mounting metal layer are sequentially arranged along a third direction. At least a part of the fourth mounting metal layer is located in the groove. The third direction is parallel to the plane on which the side, away from the first metal brazed substrate, of the chips is located, and the third direction is perpendicular to the first direction.

In this possible implementation, a plurality of chipsets help improve operation efficiency of the power module.

According to the first aspect, in a possible implementation, the power module further includes an input terminal and an output terminal. The input terminal and the output terminal are located at two opposite ends of the first metal brazed substrate along the first direction. The power module with the metal brazed substrate is a half-bridge power module. The input terminal includes a first positive power pin, a second positive power pin, and a third negative power pin. The first positive power pin is electrically connected to the first mounting metal layer. The second positive power pin is electrically connected to the third mounting metal layer. The third negative power pin is electrically connected to the fourth mounting metal layer. The output terminal is electrically connected to the second mounting metal layer.

In this possible implementation, three power pins are arranged at the input terminal. This helps increase a quantity of current flow paths of the power module at the input terminal, reduce parasitic inductance in a power loop, and reduce switching loss.

According to the first aspect, the plurality of chipsets include a first chipset, a second chipset, a third chipset, and a fourth chipset. The first chipset is located on the first mounting metal layer, the second chipset is located on the second mounting metal layer, the third chipset is located on the third mounting metal layer, and the fourth chipset is located on the second extension portion. A connecting arm on the first chipset is electrically connected to the second mounting metal layer, a connecting arm on the second chipset is electrically connected to the fourth mounting metal layer, and a connecting arm on the third chipset is electrically connected to the second mounting metal layer. The first chipset, the second chipset, the fourth chipset, and the third chipset are sequentially arranged along the third direction. The connecting arm on the first chipset is electrically connected to the first extension portion, the connecting arm on the second chipset is electrically connected to the fourth mounting metal layer, the connecting arm on the third chipset is electrically connected to the second extension portion, and a connecting arm on the fourth chipset is electrically connected to the fourth mounting metal layer.

In this possible implementation, the power module is a half-bridge power module, and the power module further includes an upper bridge part and a lower bridge part. The upper bridge part includes the first chipset, the third chipset, the first positive power pin, and the second positive power pin. The lower bridge part includes the second chipset, the fourth chipset, and the third negative power pin. Along the third direction, the upper bridge part of the half-bridge power module is located in two outer columns, the lower bridge part is located in two middle columns, the upper bridge part has two power pins located on an outer side, and the lower bridge part has one power pin located in the middle. The three power pins and the clip are designed, so that parasitic inductance and switching loss of the power loop are reduced.

According to the first aspect, in a possible implementation, the power module further includes a second metal brazed substrate and an electronic component, the second metal brazed substrate is located on the first metal brazed substrate, and the electronic component is located on a side, away from the first metal brazed substrate, of the second metal brazed substrate, and is electrically connected to the second metal brazed substrate.

The electronic component usually has a small size. Therefore, if the electronic component is directly welded to the first metal brazed substrate, an insulation trench needs to be provided on a metal layer of the first metal brazed substrate, and two electrodes of the electronic component are electrically connected to metal layers on two sides of the insulation trench. If the insulation trench is provided on the first metal brazed substrate, layout space for chips is reduced. In addition, because a large quantity of chips are arranged on the first metal brazed substrate, a pre-arranged chip or another electronic component may be damaged if a trench is provided on the metal layer of the first metal brazed substrate through etching.

In this possible implementation, the electronic component is connected through the second metal brazed substrate, so that a welding process for the electronic component is simple. Compared with the manner in which the electronic component is directly welded to the metal layer of the first metal brazed substrate, this can omit the step of providing the insulation trench on the metal layer of the first metal brazed substrate, so that a circuit design on the first metal brazed substrate is simpler. An insulation trench may be pre-provided on the second metal brazed substrate based on a size of the electronic component and positions of the two electrodes of the electronic component. The insulation trench is provided on the second metal brazed substrate through etching, so that performance of the chips on the first metal brazed substrate is not affected. Then the electronic component is electrically connected to the second metal brazed substrate.

According to the first aspect, in a possible implementation, a terminal metal layer is further arranged on a surface, facing the chips, of the first metal brazed substrate, the terminal metal layer is located at an end of the first metal brazed substrate along the first direction, the second metal brazed substrate is disposed close to the terminal metal layer, and the terminal metal layer is connected to the second metal brazed substrate through a second conducting wire.

In this possible implementation, the second metal brazed substrate is disposed close to the terminal metal layer, to reduce a length of a wire between the second metal brazed substrate and the terminal metal layer. This helps improve space utilization of the power module.

According to the first aspect, in a possible implementation, the electronic component includes a thermistor, and the thermistor is configured to monitor temperature of the chips.

According to the first aspect, in a possible implementation, at least one chip further includes a gate, the electronic component is a gate resistor, and the second metal brazed substrate includes a first substrate electrode and a second substrate electrode that are insulated and spaced apart from each other. Two ends of the gate resistor are electrically connected to the first substrate electrode and the second substrate electrode respectively. The first substrate electrode is configured to receive a drive current. The second substrate electrode is electrically connected to the gate of the chip through a first conducting wire.

In this possible implementation, the gate resistor is connected through the second metal brazed substrate, so that a welding process for the gate resistor is simple.

According to the first aspect, in a possible implementation, along the second direction, a first bonding layer is further provided between the first metal brazed substrate and a side, away from the clip, of the chips. The first bonding layer includes at least one of a solder and a sintered material.

In this possible implementation, the chips are fastened to the first metal brazed substrate through sintering or welding. This helps improve stability of connection between the chips and the first metal brazed substrate.

According to the first aspect, in a possible implementation, the power module further includes a heat sink, and the heat sink is located on a side, away from the chips, of the first metal brazed substrate.

According to the first aspect, in a possible implementation, the power module further includes a fastening layer. Along the second direction, the fastening layer is located between the heat sink and the side, away from the chips, of the first metal brazed substrate. The fastening layer includes at least one of a solder and a sintered material. The second direction is perpendicular to the plane on which the side, away from the first metal brazed substrate, of the chips is located.

To improve heat dissipation effect, the heat sink may be fastened to the side, away from the chips, of the first metal brazed substrate through the fastening layer. Compared with a manner in which the heat sink is bonded to the first metal brazed substrate through thermally conductive silicone, in a manner of sintering or welding, heat conduction effect is better than that of the thermally conductive silicone.

According to the first aspect, in a possible implementation, the clip is in an integrated structure.

In this possible implementation, the integrated structure can improve current flow smoothness, reduce current flow resistance, improve current equalization, reduce inductance, and further improve reliability of the clip.

According to the first aspect, in a possible implementation, the power module further includes a power pin, the power pin is electrically connected to the first metal brazed substrate, and the power pin includes at least one bent structure.

During application of the power module, the power pin may be subject to large stress. For example, when the power pin is connected to a battery pack, the power pin may be subject to large stress. Because the power pin is provided with the bent structure, the bent structure helps buffer the stress. This reduces a possibility that the plastic package body may crack due to the stress applied to the power pin, and also reduces a possibility that the input terminal or the output terminal is damaged due to the stress applied to the power pin.

According to the first aspect, in a possible implementation, when a quantity of chips in the chipset is not less than 3, all chips in the chipset are arranged at equal spacings along the first direction. This helps further improve consistency between parasitic parameters of parallel chips, and therefore optimizes dynamic current equalization between a plurality of parallel chips.

According to a second aspect, this application provides a power conversion apparatus, including a circuit board and the power module according to the first aspect, where the power module is disposed on the circuit board.

According to a third aspect, this application provides a powertrain, including the power conversion apparatus according to the second aspect and a drive motor connected to the power conversion apparatus.

According to a fourth aspect, this application provides a photovoltaic system, including a photovoltaic module and the power conversion apparatus according to the second aspect.

### BRIEF DESCRIPTION OF DRAWINGS

FIG. 1 is a diagram of a structure of a vehicle according to an embodiment of this application;
FIG. 2 is a block diagram of a structure of a powertrain according to an embodiment of this application;
FIG. 3 is a diagram of a structure of a photovoltaic system according to an implementation of this application;
FIG. 4 is a three-dimensional diagram of assembly of a power module according to an embodiment of this application;
FIG. 5 is a three-dimensional diagram of assembly of the power module shown in FIG. 4 from another perspective;
FIG. 6 is a schematic three-dimensional exploded view of the power module shown in FIG. 4;
FIG. 7 is a diagram of a laminated structure of a power module according to an embodiment of this application;
FIG. 8 is a diagram of a chipset disposed on a first metal brazed substrate;
FIG. 9 is a schematic plan view of a chip according to an embodiment of this application;
FIG. 10a is a diagram of assembly of a first metal brazed substrate, a chipset, and a clip;
FIG. 10b is a schematic enlarged view of a partial region A1 in FIG. 10a;
FIG. 11a is a diagram of assembly of a first metal brazed substrate, a chipset, and a clip from another perspective;
FIG. 11b is a schematic enlarged view of a partial region A2 in FIG. 11a;
FIG. 12 is a three-dimensional diagram of a clip according to an embodiment of this application;
FIG. 13a is a perspective view of assembly of a first metal brazed substrate, a chipset, and a clip;
FIG. 13b is a schematic enlarged view of a partial region A3 shown in FIG. 13a;
FIG. 14 is a top view of assembly of a first metal brazed substrate, a chipset, and a clip;
FIG. 15 is a top view of assembly of a first metal brazed substrate and a chipset;
FIG. 16a is a three-dimensional diagram of assembly of a power module without a plastic package body;
FIG. 16b is a schematic enlarged view of a partial region A4 in FIG. 16a;
FIG. 17 is a three-dimensional diagram of a clip according to an embodiment of this application; and
FIG. 18 is a diagram of connection between a chip and a part of a clip according to an embodiment of this application.

### DESCRIPTION OF EMBODIMENTS

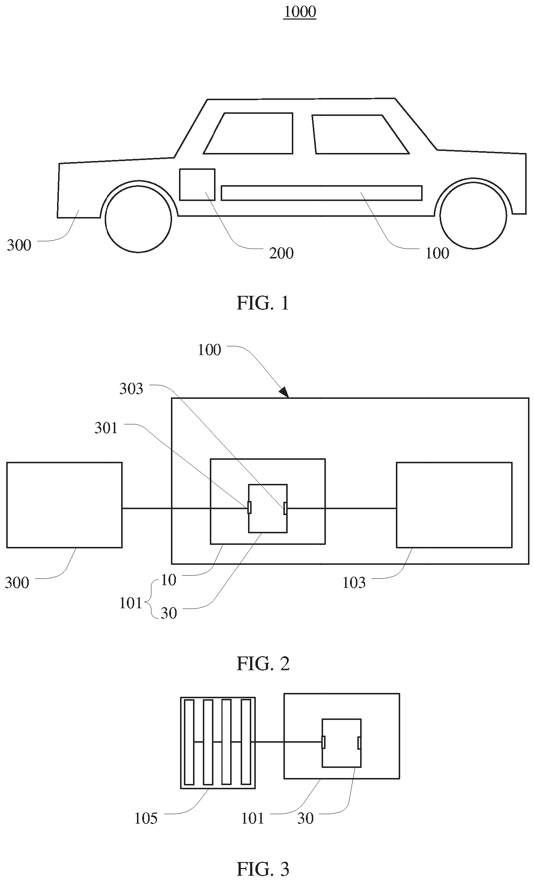

FIG. 1 is a diagram of a structure of a vehicle according to an embodiment of this application. The vehicle 1000 includes a vehicle body 300, a battery pack 200, and a powertrain 100. Both the battery pack 200 and the powertrain 100 are mounted on the vehicle body 300. The battery pack 200 is configured to provide a direct current for the powertrain 100. The powertrain 100 is configured to provide power for the vehicle 1000. The vehicle 1000 further includes another necessary or unnecessary structure. Details are not described herein in this application.

FIG. 2 is a block diagram of a structure of a powertrain according to an embodiment of this application. The powertrain 100 includes a power conversion apparatus 101 and a drive motor 103. The power conversion apparatus 101 includes a circuit board 10 and a power module 30 disposed on the circuit board 10. The power module 30 includes an input terminal 301 and an output terminal 303. The input terminal 301 is a direct current input terminal, and the output terminal 303 is an alternating current output terminal. The input terminal 301 of the power module 30 is electrically connected to the battery pack 200, and the output terminal 303 of the power module 30 is electrically connected to the drive motor 103. The power module 30 is configured to convert a direct current output by the battery pack 200 into an alternating current, and transmit the alternating current to the drive motor 103. The power module 30 is a semiconductor apparatus for converting a voltage, a current, a cycle, and the like of the direct current output by the battery pack 200.

FIG. 3 is a diagram of a structure of a photovoltaic system according to an implementation of this application. The power module 30 in this application may be further used in the photovoltaic system. The photovoltaic system includes a power conversion apparatus 101 and a photovoltaic module 105. The photovoltaic module 105 is electrically connected to the power conversion apparatus 101. A direct current produced by the photovoltaic module 105 is converted into an alternating current by the power module 30. The alternating current output by the power module 30 is transmitted to an electric device, for example, a base station or a data center.

The power module usually includes a copper-clad substrate and a plurality of chips. An electrical connection of a semiconductor chip in the power module is mainly implemented by using an aluminum wire welding technology. An electrode of the semiconductor chip is connected to a metal layer on a surface of the substrate through an aluminum wire. However, when a large quantity of chips are arranged in the power module, a quantity of aluminum wires also increases correspondingly. A large quantity of aluminum wires leads to an increase of parasitic inductance of the power module. In addition, when a plurality of chips are connected in parallel, a plurality of aluminum wires are used for connection. This leads to uneven currents between the plurality of chips connected in parallel. The uneven currents lead to uneven heat generation by the chips connected in parallel. Severe local heat generation affects performance of the chips, and therefore affects performance of the power module.

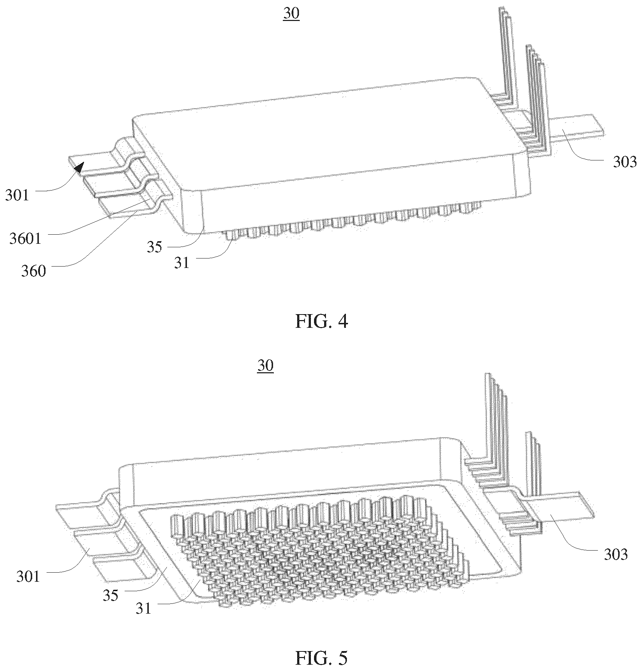

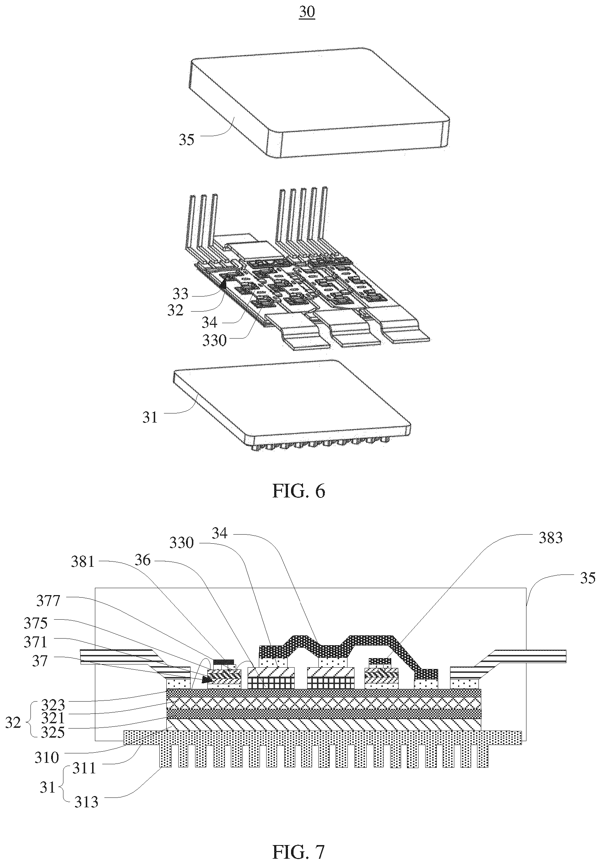

Based on this, an embodiment of this application provides a power module 30. FIG. 4 is a three-dimensional diagram of assembly of a power module according to an embodiment of this application. FIG. 5 is a three-dimensional diagram of assembly of the power module shown in FIG. 4 from another perspective. FIG. 6 is a schematic three-dimensional exploded view of the power module shown in FIG. 4. The power module 30 further includes a heat sink 31, a first metal brazed substrate 32, a chipset 33, a clip 34, and a plastic package body 35. The first metal brazed substrate 32 is mounted on a side of the heat sink 31. The heat sink 31 is configured to dissipate heat for the power module 30. The chipset 33 is disposed on the first metal brazed substrate 32. The chipset 33 includes a plurality of chips 330. The clip 34 is disposed on a side, away from the first metal brazed substrate 32, of a corresponding chipset 33, and is configured to connect a plurality of chips 330 in the chipset 33 in parallel. The plastic package body 35 is wrapped around the first metal brazed substrate 32, a plurality of chipsets 33, and a plurality of clips 34. It can be understood that the chipset 33 includes at least two chips 330. Both an input terminal 301 and an output terminal 303 are connected to the first metal brazed substrate 32.

In a possible implementation, still as shown in FIG. 4, the input terminal 301 and the output terminal 303 each include a power pin 360, the input terminal 301 is connected to the battery pack 200 through a power pin 360, and the output terminal 303 is connected to the battery pack 200 through a power pin 360. The power pin 360 includes at least one bent structure 3601, and the bent structure 3601 is configured to buffer stress. The power pins 360 of the input terminal 301 and the output terminal 303 are partially exposed from the plastic package body 35.

During application of the power module 30, the power pin 360 may be subject to large stress. For example, when the power pin 360 is connected to the battery pack 200, the power pin 360 may be subject to large stress. Because the power pin 360 is provided with the bent structure 3601, the bent structure 3601 helps buffer the stress. This reduces a possibility that the plastic package body may crack due to the stress applied to the power pin 360, and also reduces a possibility that the input terminal 301 or the output terminal 303 is damaged due to the stress applied to the power pin 360.

The power pin 360 may be made of a copper bar, an aluminum bar, or the like. The power pin 360 usually has a large width due to an excessively large current. The power pin 360 is connected to an external connecting bar (or a metal terminal) through a bolt or laser welding or in another manner. The power pin 360 may be partially exposed from the plastic package body 35.

FIG. 7 is a diagram of a laminated structure of a power module according to an embodiment of this application. A heat sink 31 is located on a side, away from a chip 330, of a first metal brazed substrate 32. The heat sink 31 may be a water-cooled heat sink or an air-cooled heat sink. This is not limited herein. The heat sink 31 is configured to dissipate heat for the power module 30, to improve power density of the power module 30. Along a second direction, the heat sink 31 is connected to the side, away from the chip 330, of the first metal brazed substrate 32 through a fastening layer 310. In this implementation, to improve heat dissipation effect, the fastening layer 310 is a solder. To be specific, the heat sink 31 may be welded to the side, away from the chip 330, of the first metal brazed substrate 32 through the solder. Compared with a manner in which the heat sink 31 is bonded to the first metal brazed substrate 32 through thermally conductive silicone, in the manner of welding, heat conduction effect of a welding material is better than that of the thermally conductive silicone.

It can be understood that the fastening layer 310 may alternatively be a sintered material. The fastening layer 310 includes at least one of the solder and the sintered material.

The heat sink 31 includes a heat sink base plate 311 and heat sink fins 313 arranged on the heat sink base plate 311. The heat sink fins 313 may be exposed from the plastic package body 35.

The first metal brazed substrate 32 includes a first insulation substrate 321, a mounting metal layer 323, and a fastening metal layer 325 that are stacked. In some implementations of this application, the first metal brazed substrate 32 may be an active metal brazed (Active metal brazed, AMB) substrate. The AMB substrate has good comprehensive properties such as thermal conductivity and mechanical strength. The first insulation substrate 321 may be a ceramic substrate. The ceramic substrate may be a Si₃N₄ or AlN ceramic substrate or the like. The mounting metal layer 323 and the fastening metal layer 325 may be copper (Cu). The Cu may be welded to the first insulation substrate 321 by using a welding process. It can be understood that, in this application, the first insulation substrate 321 is not limited to the ceramic substrate, and may be an insulation substrate made of another material. The mounting metal layer 323 may be aluminum or other metal, and the fastening metal layer 325 may be aluminum or other metal. A line is arranged in the mounting metal layer 323. A device on the first metal brazed substrate 32 may be connected to a metal layer of the first metal brazed substrate 32 through one or more times of welding.

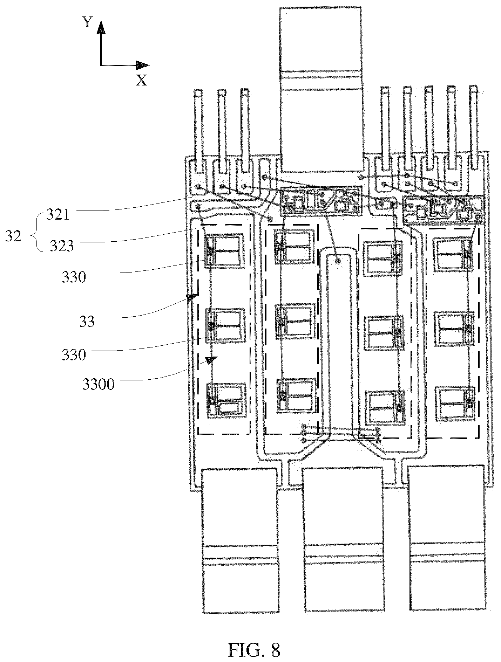

The chipset 33 is located on a side, away from the first insulation substrate 321, of the mounting metal layer 323. FIG. 8 is a diagram of a chipset disposed on a first metal brazed substrate. A plurality of chips 330 in the chipset 33 are arranged in a straight line along a first direction. The plurality of chips 330 in the chipset 33 are arranged at equal spacings along the first direction, to improve consistency between parasitic parameters of parallel chips 330 in the chipset 33, and further optimize dynamic current equalization between a plurality of parallel chips 330. The first direction is parallel to a plane on which a side, away from the first metal brazed substrate 32, of the chips 330 is located. A second direction is perpendicular to the plane on which the side, away from the first metal brazed substrate 32, of the chips 330 is located. A third direction is parallel to the plane on which the side, away from the first metal brazed substrate 32, of the chips 330 is located. Any two of the first direction, the second direction, and the third direction are perpendicular to each other. In some implementations of this application, the first direction may be a Y direction shown in FIG. 8, the third direction may be a direction along which the first insulation substrate 321 and the mounting metal layer 323 are stacked, and the third direction may be an X direction shown in FIG. 8. It can be understood that, when a quantity of chips 330 in the chipset 33 is not less than 3, all chips 330 in the chipset 33 are arranged at equal spacings along the first direction. In this application, it is not necessarily required that the plurality of chips 330 in the chipset 33 be arranged at equal spacings along the first direction.

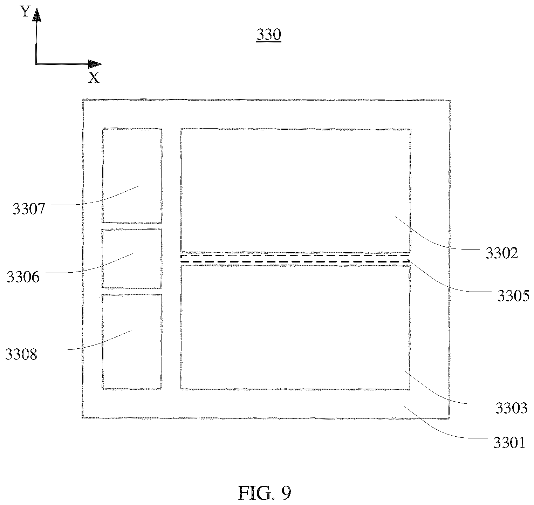

FIG. 9 is a schematic plan view of a chip according to an embodiment of this application. Each chip 330 includes a chip body 3301, a first source 3302, a second source 3303, a gate wire 3305, a gate 3306, a first Kelvin source 3307, and a second Kelvin source 3308. The first source 3302, the second source 3303, the gate wire 3305, the gate 3306, the first Kelvin source 3307, and the second Kelvin source 3308 are all arranged on the chip body 3301. The gate wire 3305 is located in the chip 330.

The first source 3302, the second source 3303, the gate wire 3305, the gate 3306, the first Kelvin source 3307, and the second Kelvin source 3308 are all electrically connected to the mounting metal layer 323. The first source 3302, the second source 3303, the gate wire 3305, the gate 3306, the first Kelvin source 3307, and the second Kelvin source 3308 may be arranged on the chip body 3301 in two columns. The first source 3302, the second source 3303, and the gate wire 3305 are sequentially arranged in a first column along the first direction. The gate 3306, the first Kelvin source 3307, and the second Kelvin source 3308 are sequentially arranged in a second column along the first direction. The first column and the second column are arranged along the third direction. The second direction, the first direction, and the third direction are different from each other.

In some implementations of this application, the chip 330 may be a metal-oxide-semiconductor field-effect transistor (Metal-Oxide-Semiconductor Field-Effect Transistor, MOSFET). A material of the chip body 3301 is SIC (silicon carbide). The SIC can increase a working frequency of the chip 330, and can reduce a size of the chip 330 at a same working frequency, so that more space can be reserved on the first metal brazed substrate 32 for mounting electronic components, such as a thermistor or a gate resistor, of the power module 30. In addition, a higher working frequency of the chip 330 can help reduce sizes of electronic components, such as a capacitor and a coil, around the power module 30.

In some implementations of this application, first columns formed by first sources 3302, second sources 3303, and gate wires 3305 on all chips 330 in one chipset 33 are located on same sides of the chips 330. To be specific, all chips 330 in one chipset 33 face a same direction.

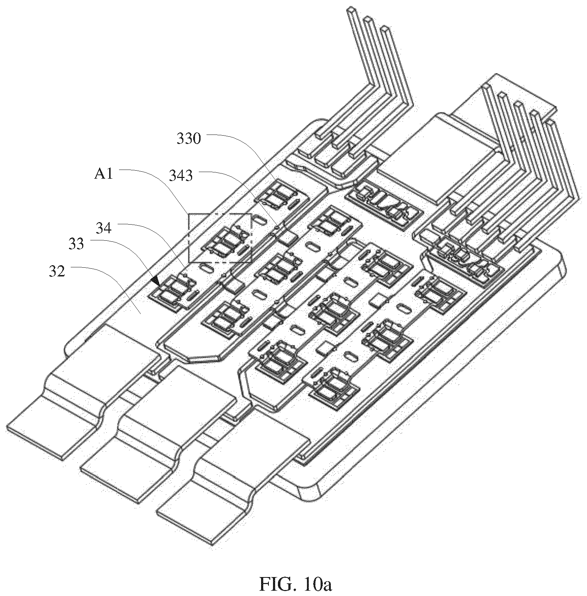

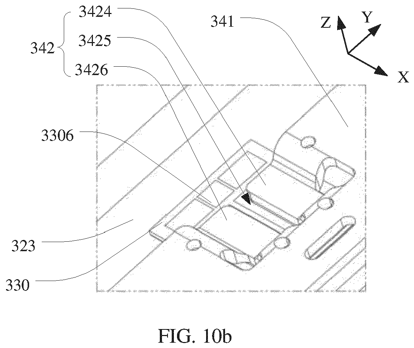

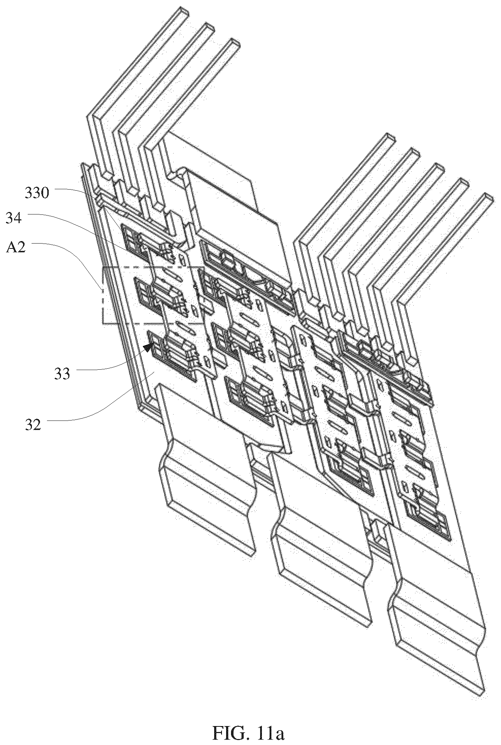

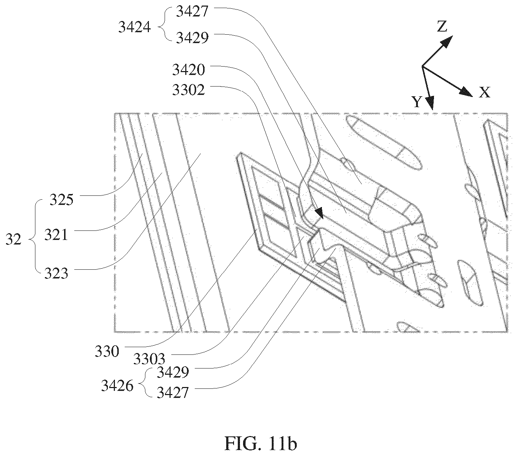

FIG. 10a is a diagram of assembly of a first metal brazed substrate, a chipset, and a clip. FIG. 10b is a schematic enlarged view of a partial region A1 in FIG. 10a. FIG. 11a is a diagram of assembly of a first metal brazed substrate, a chipset, and a clip from another perspective. FIG. 11b is a schematic enlarged view of a partial region A2 in FIG. 11a. The clip 34 covers a side, away from the first metal brazed substrate 32, of the chipset 33. The clip 34 is electrically connected to a first source 3302, and the clip 34 is electrically connected to a second source 3303.

In the related art, an electrical connection of a semiconductor chip in a power module is mainly implemented by using an aluminum wire welding technology. When a large quantity of chips are arranged in the power module, a quantity of aluminum wires also increases correspondingly. A large quantity of aluminum wires leads to an increase of parasitic inductance of the power module. In addition, when a plurality of chips are connected in parallel, a plurality of aluminum wires are used for connection. This leads to uneven currents between the plurality of chips connected in parallel. The uneven currents lead to uneven heat generation by the chips connected in parallel. Severe local heat generation affects performance of the chips, and therefore affects performance of the power module.

In this application, a plurality of chips 330 in a chipset 33 are connected in parallel through one clip 34. A connection path on the clip 34 is larger than that on an aluminum wire. This enhances connection between the plurality of chips 330 in the chipset 33 and improves consistency between parasitic parameters of parallel chips 330, and therefore optimizes dynamic current equalization between a plurality of parallel chips 330. In addition, the clip 34 can further improve structural reliability of interconnection between the plurality of chips 330, and ensure stability of current transmission. In addition, compared with a case in which a plurality of chips 330 are connected in parallel through a plurality of aluminum wires, in the case in which the clip 34 is disposed, a structure of the power module 30 can be simplified.

Contact between an aluminum wire and a chip is point contact, and the aluminum wire is very likely to be detached from the chip. However, contact between the clip 34 and the chips 330 is surface contact, so that strength of connection between the clip 34 and the chips 330 is improved. This enhances structural reliability between the plurality of chips 330 and ensures stability of current transmission.

In addition, the chips 330 in the chipset 33 are arranged in a straight line along a first direction, and the clip 34 covers the side, away from the first metal brazed substrate, of the chipset 33. In this way, two adjacent chips 330 are connected through a shortest straight path.

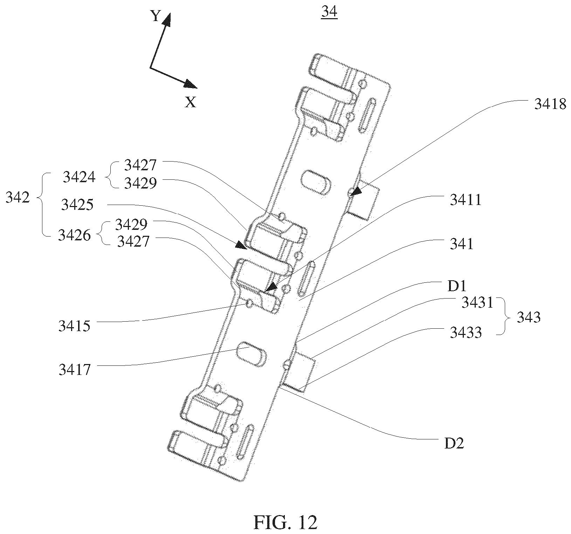

Refer to FIG. 10a, FIG. 10b, FIG. 11a, FIG. 11b, and FIG. 12. FIG. 12 is a three-dimensional diagram of a clip according to an embodiment of this application. The clip 34 includes a body 341, a plurality of connecting units 342, and at least one connecting arm 343. The body 341 covers a side, away from a first insulation substrate 321, of a mounting metal layer 323. The plurality of connecting units 342 are fastened to the body 341. Every two adjacent connecting units 342 are connected through the body 341 along a first direction. In some implementations of this application, every two adjacent chips 330 in the chipset 33 form a gap 3300 along the first direction (as shown in FIG. 8). An orthographic projection of a body 341 connected between two connecting units 342 along the first direction at least partially falls within a region, on the first metal brazed substrate 32, in which a corresponding gap 3300 is located. The connecting units 342 are in contact with first sources 3302 and second sources 3303 to implement parallel connection between all chips 330 in the chipset 33. The connecting arm 343 is connected to the mounting metal layer 323.

The clip 34 connects first sources 3302 of a plurality of chips 330 in the chipset 33 to the first metal brazed substrate 32, and connects second sources 3303 of the plurality of chips 330 to the first metal brazed substrate 32. Each connecting unit 342 is electrically connected to a corresponding chip 330. Every two adjacent connecting units 342 are connected through the body 341 along the first direction. To be specific, the clip 34 implements connection between first sources 3302 of every two chips 330 and connection between second sources 3303 of the two chips 330 with shortest straight paths. This helps minimize interconnection parasitic inductance between the plurality of chips 330 in the chipset 33, and reduce a risk of high-frequency oscillation during a switching process or under a short-circuit working condition at a high voltage and a large current.

In some implementations of this application, the clip 34 is a metal sheet, and the clip 34 is in an integrated structure formed through stamping. It can be understood that a material of the clip 34 is not limited in this application, and a molding manner for the clip 34 is not limited in this application, provided that the clip 34 can conduct electricity.

In some implementations of this application, the body 341 is approximately in a flat plate structure, and the body 341 includes a plurality of connecting holes 3411 that are provided at spacings along the first direction and that are used for disposing the connecting units 342.

A quantity of connecting units 342 corresponds to a quantity of chips 330 in the chipset 33. Each connecting unit 342 is disposed with respect to one connecting hole 3411. The connecting unit 342 includes a first contact portion 3424, an avoidance space 3425, and a second contact portion 3426 that are sequentially arranged along the first direction. The first contact portion 3424 is connected to a hole wall of the connecting hole 3411, and the second contact portion 3426 is connected to a hole wall of the connecting hole 3411. The first contact portion 3424 is in contact with the first source 3302, and the second contact portion 3426 is in contact with the second source 3303. The avoidance space 3425 and a gate wire 3305 are arranged along a second direction. The avoidance space 3425 has an avoidance opening arranged toward the gate wire 3305. A position of the avoidance opening is arranged with respect to a position of the gate wire 3305.

In some implementations of this application, the first contact portion 3424 and the second contact portion 3426 are solder pads, the first contact portion 3424 is connected to the first source 3302 through welding, and the second contact portion 3426 is connected to the first source 3302 through welding.

The chip has a quite small size, and the gate wire is likely to be damaged due to stress, leading to failure of the chip. In this application, the avoidance space 3425 and the gate wire 3305 are arranged along the second direction. To be specific, the avoidance space 3425 is provided at a position, on the clip 34, that corresponds to the gate wire 3305. In this way, the clip 34 is disposed away from the gate wire 3305, so that stress applied by the clip 34 to the gate wire 3305 is reduced. This helps reduce a possibility that the gate wire 3305 is damaged, and extends cycle life of the power module 30.

In some implementations of this application, the avoidance space 3425 is a groove that passes through the clip 34 along the second direction, and the avoidance space 3425 extends from an end, away from a connecting section 3427 of the second contact portion 3426, of a contact section 3429 of the second contact portion 3426 to an end, connected to the connecting hole 3411, of the connecting section 3427 of the second contact portion 3426, to increase a length of the avoidance space 3425, and further reduce stress applied by the clip 34 to the gate wire 3305.

In some implementations of this application, the first contact portion 3424 and the second contact portion 3426 each include a connecting section 3427 and a contact section 3429 that are fastened to each other. The connecting section 3427 bends relative to the body 341. A connecting section 3427 of the first contact portion 3424 is connected between the hole wall of the connecting hole 3411 and a contact section 3429 of the first contact portion 3424. The connecting section 3427 of the second contact portion 3426 is connected between the hole wall of the connecting hole 3411 and the contact section 3429 of the second contact portion 3426. A vertical distance between the contact section 3429 and the chip 330 along the second direction is less than a vertical distance between the body 341 and the chip 330 along the second direction. The contact section 3429 is connected to the body 341 through the connecting section 3427. In this way, the body 341 and the mounting metal layer 323 are separated by a plastic package body 35. In some implementations of this application, the connecting section 3427 includes a curved-surface structure. With the curved-surface structure, a possibility that the clip 34 breaks during molding can be reduced. It can be understood that the connecting section 3427 may alternatively include a flat plate structure.

The plastic package body is subject to delamination at a bent position of a mechanical part or in a continuous large-area planar region of a mechanical part. This affects sealing performance of the power module. A first locking hole 3415 is provided at a joint between the connecting section 3427 and the body 341, and a second locking hole 3417 is provided on the body 341. The first locking hole 3415 and the second locking hole 3417 are filled with the plastic package body 35. The first locking hole 3415 is provided at the joint between the connecting section 3427 and the body 341, and the first locking hole 3415 is filled with the plastic package body 35, so that a possibility that the plastic package body 35 is delaminated at the joint between the body 341 and the connecting section 3427 is reduced, and/or a possibility that the plastic package body 35 is delaminated and spreads to a surface of the chip 330 is reduced. This helps improve sealing performance of the power module 30. The body 341 is provided with the second locking hole 3417, and the second locking hole 3417 is filled with the plastic package body 35, so that a possibility that the plastic package body 35 is delaminated on the body 341 is reduced, or a possibility that the plastic package body 35 is delaminated and spreads to a surface of the chip 330 is reduced. This helps improve sealing performance of the power module 30. A shape of the first locking hole 3415 is not limited to a circular shape, an elliptic shape, a slotted hole shape, or the like. A shape of the second locking hole 3417 is not limited to a circular shape, an elliptic shape, a slotted hole shape, or the like.

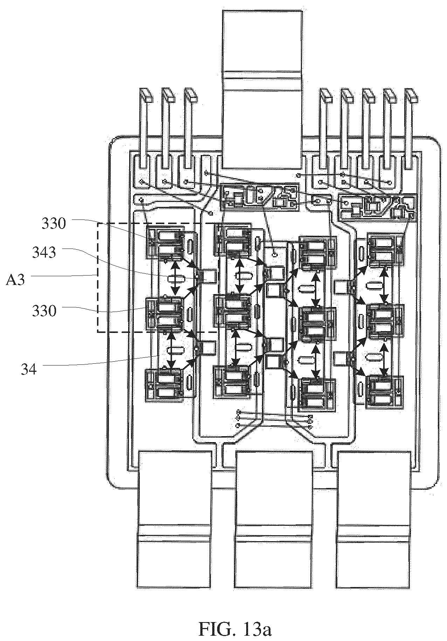

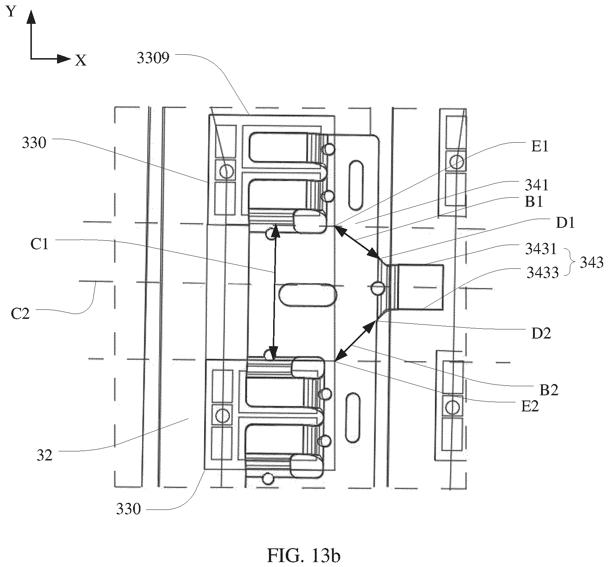

FIG. 13a is a perspective view of assembly of a first metal brazed substrate, a chipset, and a clip. FIG. 13b is a schematic enlarged view of a partial region A3 shown in FIG. 13a. Each connecting arm 343 is disposed with respect to two adjacent chips 330 in the chipset 33, and the connecting arm 343 is connected to the first metal brazed substrate 32. A shortest distance between the connecting arm 343 and one of the two adjacent chips 330 is a first shortest distance B1. A shortest distance between the connecting arm 343 and the other of the two adjacent chips 330 is a second shortest distance B2. A difference between the first shortest distance B1 and the second shortest distance B2 is not greater than 30% of the first shortest distance.

One of the two adjacent chips 330, the clip 34, and the first metal brazed substrate 32 form a first interconnection path, and the other chip 330, the clip 34, and the first metal brazed substrate 32 form a second interconnection path. The first interconnection path and the second interconnection path are approximately symmetric. This helps balance current paths of the chips 330 and reduce a difference between parasitic parameters of the chips 330, and therefore further improves a dynamic current equalization characteristic of parallel chips 330. A shortest distance between the connecting arm 343 and one of the two adjacent chips 330 along a first direction may be equal to or approximately equal to a shortest distance between the connecting arm 343 and the other of the two adjacent chips 330 along the first direction.

The chip 330 is approximately in a square shape. The chip 330 includes four chip edges 3309 that are connected. A joint between every two chip edges 3309 forms an intersection point. An intersection point that is of a first chip 330 of two adjacent chips 330 in the chipset 33 and that is closest to a connecting arm 343 corresponding to the first chip 330 is E1. An intersection point that is of a second chip 330 of the two adjacent chips 330 and that is closest to a connecting arm 343 corresponding to the second chip 330 is E2. E1 and E2 are approximately arranged along the first direction. E2 is located on a side, close to the first chip 330 along the first direction, of the second chip 330; and E1 is located on a side, close to the connecting arm 343 along a third direction, of the first chip 330.

Ajoint between the connecting arm 343 and the first metal brazed substrate 32 is located on a middle line C2 of a shortest connection line C1 between the two adjacent chips 330. In some implementations of this application, the connecting arm 343 includes a first edge 3431 and a second edge 3433 that are arranged opposite to each other along the first direction. Both the first edge 3431 and the second edge 3433 are fastened to the body 341. A connection point between the first edge 3431 and the body 341 is D1, and a connection point between the second edge 3433 and the body 341 is D2. A shortest distance between D1 and E1 is the first shortest distance B1. The connection point between the second edge 3433 and the body 341 is D2, and a shortest distance between D1 and E2 is the second shortest distance B2.

In some implementations of this application, the connecting arm 343 bends relative to the body 341, and a third locking groove 3418 is provided at a joint between the connecting arm 343 and the body 341.

In some implementations of this application, the connecting arm 343 may be axisymmetric with respect to the middle line C2, so that a plurality of clips 34 with a same structure can be used in the power module 30. This facilitates assembly of the power module 30 and reduces costs of the power module 30. It can be understood that the connecting arm 343 may not be axisymmetric with respect to the middle line C2.

It can be understood that a structure of the connecting arm 343 is not limited in this application.

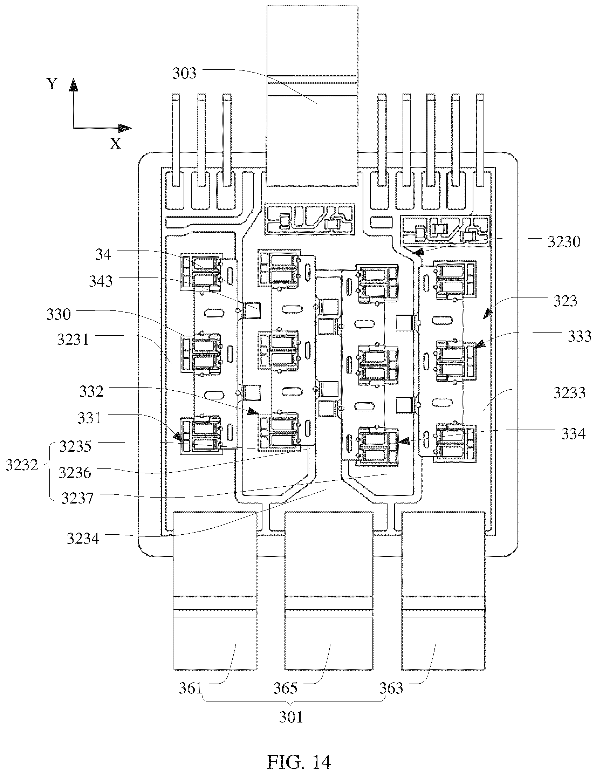

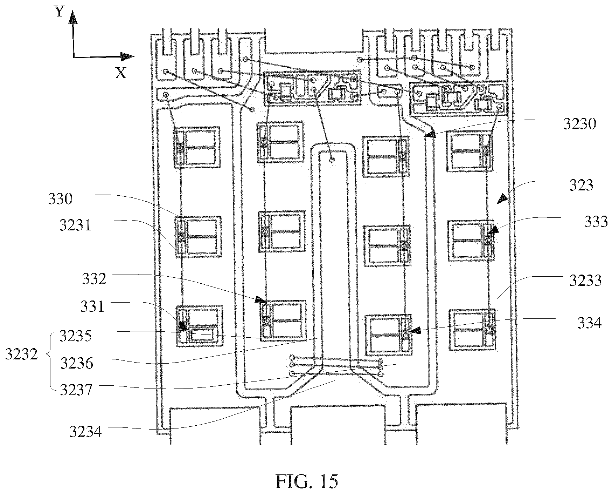

In some implementations of this application, FIG. 14 is a top view of assembly of a first metal brazed substrate, a chipset, and a clip, and FIG. 15 is a top view of assembly of a first metal brazed substrate and a chipset. There are a plurality of mounting metal layers 323, and the plurality of mounting metal layers 323 are arranged on a first insulation substrate 321 at spacings. A trench 3230 is formed between every two adjacent mounting metal layers 323, so that the plurality of mounting metal layers 323 are insulated from each other. The plurality of mounting metal layers 323 include a first mounting metal layer 3231, a second mounting metal layer 3232, a third mounting metal layer 3233, and a fourth mounting metal layer 3234. The first mounting metal layer 3231 and the third mounting metal layer 3233 are electrically connected to an input terminal 301. The second mounting metal layer 3232 is electrically connected to an output terminal 303. The fourth mounting metal layer 3234 is electrically connected to the input terminal 301. The first mounting metal layer 3231, the second mounting metal layer 3232, and the third mounting metal layer 3233 are sequentially arranged along a third direction. The second mounting metal layer 3232 includes a first extension portion 3235, a groove 3236, and a second extension portion 3237. An end of the first extension portion 3235 is connected to an end of the second extension portion 3237. The first extension portion 3235 and the second extension portion 3237 enclose the groove 3236 for accommodating the fourth mounting metal layer 3234. At least a part of the fourth mounting metal layer 3234 is located in the groove 3236. Along the third direction, the first mounting metal layer 3231 and the first extension portion 3235 are located on a first side of the fourth mounting metal layer 3234, and the third mounting metal layer 3233 and the second extension portion 3237 are located on a second side of the fourth mounting metal layer 3234. It can be understood that positions of the first mounting metal layer 3231, the second mounting metal layer 3232, the third mounting metal layer 3233, and the fourth mounting metal layer 3234 are not limited in this application.

In some implementations of this application, there are a plurality of chipsets 33, to help improve operation efficiency of the power module 30. The plurality of chipsets 33 include a first chipset 331, a second chipset 332, a third chipset 333, and a fourth chipset 334. The first chipset 331 is located on the first mounting metal layer 3231. The second chipset 332 is located on the first extension portion 3235. The third chipset 333 is located on the third mounting metal layer 3233. The fourth chipset 334 is located on the second extension portion 3237. The first chipset 331, the second chipset 332, the fourth chipset 334, and the third chipset 333 are sequentially arranged along the third direction.

In some implementations of this application, spacings between every two adjacent chips 330 in all the chipsets 33 along a first direction are the same, to improve consistency between parasitic parameters of parallel chips 330 in all the chipsets 33 in the power module 30. For example, a spacing between every two adjacent chips 330 in the first chipset 331 along the first direction is a first spacing, a spacing between every two adjacent chips 330 in the second chipset 332 along the first direction is a second spacing, a spacing between every two adjacent chips 330 in the third chipset 333 along the first direction is a third spacing, a spacing between every two adjacent chips 330 in the fourth chipset 334 along the first direction is a fourth spacing, and the first spacing, the second spacing, the third spacing, and the fourth spacing are the same. It can be understood that, in this application, it is not required that spacings between every two adjacent chips 330 in all the chipsets 33 along the first direction be the same.

A clip 34 is disposed on a side, away from the first insulation substrate 321, of each of the first chipset 331, the second chipset 332, the third chipset 333, and the fourth chipset 334. A clip 34 on the first chipset 331 is electrically connected to the second mounting metal layer 3232. A clip 34 on the second chipset 332 is electrically connected to the fourth mounting metal layer 3234. A clip 34 on the third chipset 333 is electrically connected to the second extension portion 3237. A clip 34 on the fourth chipset 334 is electrically connected to the fourth mounting metal layer 3234.

A connecting arm 343 of the clip 34 on the first chipset 331 is electrically connected to the first extension portion 3235. A connecting arm 343 of the clip 34 on the second chipset 332 is electrically connected to the fourth mounting metal layer 3234. A connecting arm 343 of the clip 34 on the third chipset 333 is electrically connected to the second extension portion 3237. A connecting arm 343 of the clip 34 on the fourth chipset 334 is electrically connected to the fourth mounting metal layer 3234. A clip 34 is connected to a corresponding mounting metal layer 323 through a connecting arm 343. There is one or more connection points between a clip 34 and a corresponding mounting metal layer 323. Distances between each connecting arm 343 and two chips 330 closest to the connecting arm 343 are equal or approximately equal, and paths are symmetric. This helps implement symmetry of interconnection paths between chips 330 and mounting metal layers 323 connected to the chips 330, balance current paths of the chips 330, and reduce a difference between parasitic parameters of the chips 330, and therefore improves a dynamic current equalization characteristic of parallel chips 330.

In some implementations of this application, along the third direction, a first source 3302 of a chip 330 in the first chipset 331 is arranged on a side, close to the third chipset 333, of the chip 330; a first source 3302 of a chip 330 in the second chipset 332 is arranged on a side, close to the third chipset 333, of the chip 330; a first source 3302 of a chip 330 in the third chipset 333 is arranged on a side, close to the first chipset 331, of the chip 330; and a first source 3302 of a chip 330 in the fourth chipset 334 is arranged on a side, close to the first chipset 331, of the chip 330. To be specific, the first chipset 331 and the second chipset 332 face a same direction, and the third chipset 333 and the fourth chipset 334 face a same direction. The connecting arm 343 of the clip 34 on the first chipset 331 is arranged on a side, facing the first extension portion 3235, of a body 341 on the first chipset 331. The connecting arm 343 of the clip 34 on the second chipset 332 is arranged on a side, facing the second extension portion 3237, of a body 341 on the second chipset 332. The connecting arm 343 of the clip 34 on the third chipset 333 is arranged on a side, facing the second extension portion 3237, of a body 341 on the third chipset 333. The connecting arm 343 of the clip 34 on the fourth chipset 334 is arranged on a side, facing the first extension portion 3235, of a body 341 on the fourth chipset 334. To be specific, the clip 34 on the first chipset 331 and the clip 34 on the second chipset 332 face a same direction, and the clip 34 on the third chipset 333 and the clip 34 on the fourth chipset 334 face a same direction.

The clip 34 on the first chipset 331 and the clip 34 on the second chipset 332 face a same direction, the clip 34 on the third chipset 333 and the clip 34 on the fourth chipset 334 face a same direction, the first chipset 331 and the second chipset 332 face a same direction, and the third chipset 333 and the fourth chipset 334 face a same direction. In this way, an interconnection path between the clip 34 on the first chipset 331 and the first extension portion 3235 is approximately mirror-symmetric to an interconnection path between the clip 34 on the third chipset 333 and the second extension portion 3237, and an interconnection path between the clip 34 on the second chipset 332 and the fourth mounting metal layer 3234 is approximately mirror-symmetric to an interconnection path between the clip 34 on the fourth chipset 334 and the fourth mounting metal layer 3234. This balances current paths of the chipsets 33 and reduces a difference between parasitic parameters of the chips 330, and therefore further improves a dynamic current equalization characteristic of parallel chips 330.

In some implementations of this application, the input terminal 301 is located at a first end of the power module 30, and the output terminal 303 is located at a second end of the power module 30. Power pins at the input terminal 301 include a first positive power pin 361, a second positive power pin 363, and a third negative power pin 365. The first positive power pin 361 is electrically connected to the first mounting metal layer 3231. The second positive power pin 363 is electrically connected to the third mounting metal layer 3233. The third negative power pin 365 is electrically connected to the fourth mounting metal layer 3234. The output terminal 303 is electrically connected to the second mounting metal layer 3232. Along the third direction, the third negative power pin 365 is located between the first positive power pin 361 and the second positive power pin 363.

In some implementations of this application, the power module 30 is a half-bridge power module, and the power module 30 further includes an upper bridge part and a lower bridge part. The upper bridge part includes the first chipset 331, the third chipset 333, the first positive power pin 361, and the second positive power pin 363. The lower bridge part includes the second chipset 332, the fourth chipset 334, and the third negative power pin 365. Three power pins are arranged at the input terminal 301. This helps increase a quantity of current flow paths of the power module 30 at the input terminal 301, reduce parasitic inductance in a power loop, and reduce switching loss.

The first positive power pin 361, the first mounting metal layer 3231, the first chipset 331, the clip 34 on the first chipset 331, the first extension portion 3235, and the output terminal 303 may form a first current flow path. The second positive power pin 363, the third mounting metal layer 3233, the third chipset 333, the clip 34 on the third chipset 333, the second extension portion 3237, and the output terminal 303 may form a second current flow path. The output terminal 303, the first extension portion 3235, the second chipset 332, the clip 34 on the second chipset 332, the fourth mounting metal layer 3234, and the third negative power pin 365 may form a third current flow path. The output terminal 303, the second extension portion 3237, the fourth chipset 334, the clip 34 on the fourth chipset 334, the fourth mounting metal layer 3234, and the third negative power pin 365 may form a fourth current flow path. The first current flow path is approximately symmetric to the second current flow path, and the third current flow path is approximately symmetric to the fourth current flow path.

A current flow direction may be as follows: the first positive power pin 361, the first mounting metal layer 3231, the first chipset 331, the clip 34 on the first chipset 331, the first extension portion 3235, and the output terminal 303.

A current flow direction may be as follows: the second positive power pin 363, the third mounting metal layer 3233, the third chipset 333, the clip 34 on the third chipset 333, the second extension portion 3237, and the output terminal 303.

A current flow direction may be as follows: the output terminal 303, the first extension portion 3235, the second chipset 332, the clip 34 on the second chipset 332, the fourth mounting metal layer 3234, and the third negative power pin 365.

A current flow direction may be as follows: the output terminal 303, the second extension portion 3237, the fourth chipset 334, the clip 34 on the fourth chipset 334, the fourth mounting metal layer 3234, and the third negative power pin 365.

It can be understood that two of the first positive power pin 361, the second positive power pin 363, and the third negative power pin 365 may be negative pins, and the other of the first positive power pin 361, the second positive power pin 363, and the third negative power pin 365 may be a positive pin.

It can be understood that a quantity of power pins at the input terminal 301 is not limited, provided that the input terminal 301 includes pins with different polarities.

Still as shown in FIG. 7, a first bonding layer 36 is further provided between the mounting metal layer 323 and a side, away from a clip 34, of the chip 330. The first bonding layer 36 is configured to fasten the chip 330 to the corresponding mounting metal layer 323. In a possible implementation, the first bonding layer 36 is a sintered material. To be specific, the chip 330 is connected to the mounting metal layer 323 through the sintered material. For example, the sintered material may be made of silver paste, copper paste, or a silver film. The silver paste may include at least one of micrometer silver particle paste (Micrometer silver particle paste) and nanometer silver particle paste (Nanometer silver particle paste). The micrometer silver particle paste is silver paste prepared by using micrometer silver particles and an organic solvent, and is cost-effective and safe. Sintering is usually performed under pressure. The sintered material has high density, interfaces of bonded parts are firmly bonded, and reliability of bonding is high.

To improve reliability of bonding during sintering and reduce costs, the sintered material in this application may be made of the micrometer silver particle paste (Micrometer silver particle paste).

To improve reliability of bonding during sintering, a material may be added to the sintered material to adjust elasticity modulus, a coefficient of thermal expansion (CTE), and the like of the sintered material. For example, the sintered material includes a primary material and a filler added to the primary material. The primary material includes at least one of silver paste, copper paste, or a silver film. The filler is made of a material that can be well bonded to the primary material, and a coefficient of thermal expansion of the filler is less than a coefficient of thermal expansion of the primary material. This improves reliability of bonding during sintering.

For example, the primary material is micrometer silver particle paste. A filler is added to the micrometer silver particle paste to reduce a coefficient of thermal expansion of the micrometer silver particle paste and reduce bonding stress, so as to improve reliability of bonding during silver sintering. For example, the filler may include at least one of nickel (Ni), an Ni alloy, copper (Cu), copper-plated nickel, titanium (Ti), a Ti alloy, ferrum (Fe), an Fe alloy, a Kovar alloy (Kovar, an Fe-Ni-Co alloy 4J29), SiC powder, and the like. This is not limited herein.

In this application, the mounting metal layer 323 is usually made of copper. When the sintered material is made of silver paste or a silver film, to improve performance of bonding between the sintered material and the mounting metal layer 323, the mounting metal layer 323 may be silver-plated at a sintering position. To be specific, a region, corresponding to the sintered material, of the mounting metal layer 323 is covered by a silver-plated layer. For example, a thickness of the silver-plated layer may be controlled to range from 0.1 µm to 30 µm. If the sintered material itself can be well bonded to the first metal brazed substrate 32, silver plating may alternatively not be performed. For example, when the sintered material is made of copper paste, silver plating does not need to be performed at the sintering position of the first metal brazed substrate 32.

It can be understood that the first bonding layer 36 may alternatively be a solder. To be specific, the chip 330 is connected to the mounting metal layer 323 by using a welding process.

It can be understood that the first bonding layer 36 includes at least one of the solder and the sintered material.

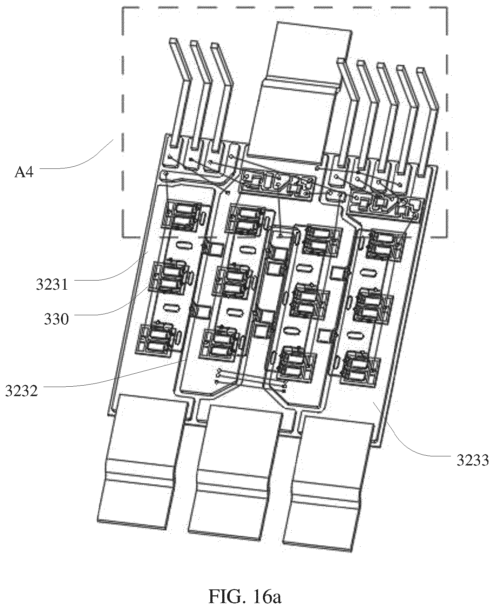

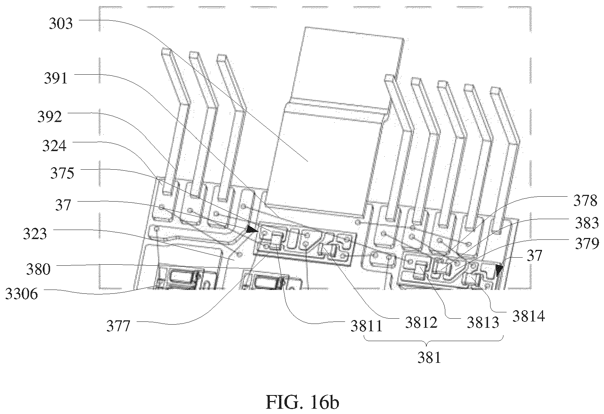

Refer to FIG. 7, FIG. 16a, and FIG. 16b. FIG. 16a is a three-dimensional diagram of assembly of a power module without a plastic package body. FIG. 16b is a schematic enlarged view of a partial region A4 in FIG. 16a. In a possible implementation, the power module 30 further includes a second metal brazed substrate 37 and an electronic component 38 (as shown in FIG. 16b). The second metal brazed substrate 37 is located on a side, away from the first insulation substrate 321, of the mounting metal layer 323 of the first metal brazed substrate 32. The electronic component 38 is located on a side, away from the first metal brazed substrate 32, of the second metal brazed substrate 37, and is electrically connected to the second metal brazed substrate 37.

The electronic component usually has a small size. Therefore, if the electronic component is directly welded to the first metal brazed substrate 32, an insulation trench needs to be provided on a metal layer of the first metal brazed substrate 32, and two electrodes of the electronic component are electrically connected to metal layers on two sides of the insulation trench. If the insulation trench is provided on the first metal brazed substrate 32, layout space for chips 330 is reduced. In addition, because a large quantity of chips 330 are arranged on the first metal brazed substrate 32, a pre-arranged chip 330 or another electronic component may be damaged if a trench is provided on the metal layer of the first metal brazed substrate 32 through etching. In this implementation, the electronic component is connected through the second metal brazed substrate 37, so that a welding process for the electronic component is simple. Compared with the manner in which the electronic component is directly welded to the metal layer of the first metal brazed substrate 32, this can omit the step of providing the insulation trench on the metal layer of the first metal brazed substrate 32, so that a circuit design on the first metal brazed substrate 32 is simpler. An insulation trench may be pre-provided on the second metal brazed substrate 37 based on a size of the electronic component and positions of the two electrodes of the electronic component. The insulation trench is provided on the second metal brazed substrate 37 through etching, so that performance of the chips 330 on the first metal brazed substrate 32 is not affected. Then the electronic component is electrically connected to the second metal brazed substrate 37.

The second metal brazed substrate 37 includes a second insulation substrate 371 and metal layers located on two sides of the second insulation substrate 371. The electronic component 38 is electrically connected to a metal layer on a side, away from the first metal brazed substrate 32, of the second insulation substrate 371.

In a possible implementation, the electronic component 38 includes a gate resistor 381 (as shown in FIG. 7 and FIG. 16b), the second metal brazed substrate 37 is located on the mounting metal layer 323, and the second metal brazed substrate 37 includes a first substrate electrode 375 and a second substrate electrode 377 that are insulated and spaced apart from each other. Two ends of the gate resistor 381 are electrically connected to the first substrate electrode 375 and the second substrate electrode 377 respectively. The first substrate electrode 375 is configured to receive a drive current. The second substrate electrode 377 is electrically connected to a gate 3306 of the chip 330 through a first conducting wire 380. The gate resistor 381 is connected through the second metal brazed substrate 37, so that a welding process for the gate resistor 381 is simple.

The first substrate electrode 375 and the second substrate electrode 377 are a part of a metal layer on the second insulation substrate 371. An insulation part between the first substrate electrode 375 and the second substrate electrode 377 is arranged based on a size of the gate resistor 381, so that the first substrate electrode 375 and the second substrate electrode 377 are insulated and spaced apart from each other.

For example, a trench is provided between the first substrate electrode 375 and the second substrate electrode 377, and the first substrate electrode 375 and the second substrate electrode 377 are insulated and spaced apart from each other based on the trench. The first substrate electrode 375, the second substrate electrode 377, and the trench may be formed by performing an etching process on a metal layer on a surface on one side of the second metal brazed substrate 37.

In some implementations of this application, as shown in FIG. 16b, a terminal metal layer 324 is further arranged on a surface, facing the chip 330, of the first metal brazed substrate 32. The terminal metal layer 324 is located at an end, at which the output terminal 303 is located, of the first metal brazed substrate 32. The second metal brazed substrate 37 is disposed close to the terminal metal layer 324. The terminal metal layer 324 is electrically connected to the second metal brazed substrate 37 through a second conducting wire 391. The second metal brazed substrate 37 is disposed close to the terminal metal layer 324, to reduce a length of a wire between the second metal brazed substrate 37 and the terminal metal layer 324. This helps improve space utilization of the power module 30.

The power module 30 further includes a signal terminal 392 (as shown in FIG. 16b). The signal terminal 392 is disposed on the terminal metal layer 324. An external control circuit sends a drive current to the signal terminal 392. After the first substrate electrode 375 receives the drive current, as shown in FIG. 16b, the drive current flows to the gate 3306 of the chip 330 by sequentially passing through the signal terminal 392, the terminal metal layer 324, the second conducting wire 391, the first substrate electrode 375, the gate resistor 381, the second substrate electrode 377, and the first conducting wire 380. After receiving the drive current, the gate 3306 can drive conduction between the first source 3302 and the second source 3303. The gate resistor 381 is configured to improve switching performance of the chip 330, and can suppress high-frequency oscillation that occurs when a plurality of chips 330 are connected in parallel. The first conducting wire 380 and the second conducting wire 391 are transmission wires, for example, aluminum wires or copper wires.

The second metal brazed substrate 37 further includes a metal layer located on a side, away from the first substrate electrode 375 and the second substrate electrode 377, of the second insulation substrate 371. The metal layer is welded to the mounting metal layer 323 on a surface of the first metal brazed substrate 32 through a solder. The solder may be at least one of a tin solder and a lead solder. The tin solder may be at least one of SnSb5, SnSb8, SnSbAg, SAC305, multi-component reinforced SAC, and SnSb10.

The gate resistor 381 may be welded to the first substrate electrode 375 and the second substrate electrode 377 through a solder.

The signal terminal 392 may be welded to the terminal metal layer 324 at an edge of the first metal brazed substrate 32 through a solder. The solder may be at least one of a tin solder and a lead solder. The tin solder may be at least one of SnSb5, SnSb8, SnSbAg, SAC305, multi-component reinforced SAC, and SnSb10.

In an implementation, when there is one gate resistor 381 and one second metal brazed substrate 37, gates 3306 of a plurality of chips 330 in the first chipset 331 are electrically connected to a gate resistor 381 on a same second metal brazed substrate 37 through conducting wires. To be specific, one gate resistor 381 controls conduction or cutoff between first sources 3302 and second sources 3303 of the plurality of chips 330.

In an implementation, when there are a plurality of gate resistors 381 and a plurality of second metal brazed substrates 37 and each gate resistor 381 is disposed on a second metal brazed substrate 37, a gate 3306 of each chip 330 is electrically connected to a gate resistor 381 on one of the second metal brazed substrates 37 through a conducting wire. To be specific, one gate resistor 381 controls conduction or cutoff between a first source 3302 and a second source 3303 of one chip 330. For example, there are a plurality of gate resistors 381, the plurality of gate resistors 381 include a first gate resistor 3811, a second gate resistor 3812, a third gate resistor 3813, and a fourth gate resistor 3814, the first chipset 331 is connected in series to the first gate resistor 3811, the second chipset 332 is connected in series to the second gate resistor 3812, the third chipset 333 is connected in series to the third gate resistor 3813, and the fourth chipset 334 is connected in series to the fourth gate resistor 3814. It can be understood that one or more of the first chipset 331, the second chipset 332, the third chipset 333, and the fourth chipset 334 are connected in series to a gate resistor 381, or the power module 30 is not provided with a gate resistor 381.

If an electronic component is directly welded to the first metal brazed substrate 32, because a current needs to pass through the electronic component, two connecting electrodes that are insulated and spaced apart from each other need to be disposed on the first metal brazed substrate 32. For example, a connecting metal layer is provided, through etching, on a metal layer on a side, away from the first insulation substrate 321, of the first metal brazed substrate 32. The connecting metal layer is insulated and spaced apart from other parts of other mounting metal layers. Then a trench is provided on the connecting metal layer through etching to form two connecting electrodes that are insulated and spaced apart from each other. In this case, a part of a connecting metal layer and a part of a metal welding layer between the two connecting electrodes need to be removed by using an etching process. A size of etching along a third direction Z is large. Consequently, an opening size of the trench between the two connecting electrodes increases. In other words, a size between the two connecting electrodes increases. However, the electronic component (for example, the gate resistor 381) has a small size and cannot be welded to the two connecting electrodes, or reliability of welding is poor.

Based on this, in this implementation, the electronic component 38 is connected through the second metal brazed substrate 37. Metal on the second metal brazed substrate 37 is directly bonded to the second insulation substrate 371, so that the formed first substrate electrode 375 and second substrate electrode 377 are also directly attached to a surface of the second insulation substrate 371. No metal welding layer is provided between the first substrate electrode 375 and the second insulation substrate 371 or between the second substrate electrode 377 and the second insulation substrate 371. No metal welding layer needs to be formed through etching when a trench is provided through etching to form the first substrate electrode 375 and the second substrate electrode 377, so that a size between the first substrate electrode 375 and the second substrate electrode 377 can be controlled to be small. This facilitates welding of an electronic component (for example, the gate resistor 381).

In an implementation, the first metal brazed substrate 32 is an active metal welded substrate. The active metal welded substrate is obtained by welding metal layers such as copper layers or aluminum layers to surfaces on two sides of an insulation substrate through metal solders. Circuits required for the power module 30, such as the mounting metal layer 323 and the terminal metal layer 324, may be obtained by etching copper layers. The first insulation substrate 321 on the first metal brazed substrate 32 may be made of a Si₃N₄ or AlN material, so that welding between the first insulation substrate 321 and the metal layers on the two sides is more reliable, and good thermal conductivity is achieved. This can improve heat dissipation effect for the power module 30.

In an implementation, the second metal brazed substrate 37 is a copper-clad ceramic substrate. The second insulation substrate 371 is an Al₂O₃ ceramic substrate or an AIN ceramic substrate, and a metal layer (for example, a copper foil) is directly bonded to the second insulation substrate 371 at high temperature. For example, the copper foil is directly bonded to the Al₂O₃ ceramic substrate at high temperature, and then the copper foil forms the first substrate electrode 375 and the second substrate electrode 377 according to a requirement. No other metal layer is provided between the copper foil and the Al₂O₃ ceramic substrate, so that a spacing between the first substrate electrode 375 and the second substrate electrode 377 is small. This facilitates welding of the gate resistor 381.

In a possible implementation, the first metal brazed substrate 32 is an insulation metal substrate. The insulation metal substrate includes an insulation resin layer and metal layers located on two sides of the insulation resin layer. When a value of a thickness of the metal layers is greater than or equal to 0.6 mm, the power module 30 has high power density, and the second metal brazed substrate 37 may be disposed for connecting an electronic component, to reduce difficulty of a welding process for the electronic component.

Still as shown in FIG. 16b, in a possible implementation, the power module 30 includes two second metal brazed substrates 37, both second metal brazed substrates 37 may be used for welding gate resistors 381, and one of the second metal brazed substrates 37 may be further used for welding a thermistor 383. In some implementations, one second metal brazed substrate 37 may be used for welding the thermistor 383.

In this implementation, the electronic component 38 further includes the thermistor 383, the thermistor 383 is disposed close to the chip 330, and the thermistor 383 is configured to monitor temperature of the chip 330. The second metal brazed substrate 37 further includes a third substrate electrode 378 and a fourth substrate electrode 379 that are insulated and spaced apart from each other. Two ends of the thermistor 383 are electrically connected to the third substrate electrode 378 and the fourth substrate electrode 379 respectively. In some implementations, the second metal brazed substrate 37 is located on a side, away from the first insulation substrate 321, of the third mounting metal layer 3233, and is adjacent to a chip 330 located on the third mounting metal layer 3233, and the thermistor 383 is configured to monitor temperature of the chip 330. To be specific, the chip 330 and the second metal brazed substrate 37 for connecting the thermistor 383 are located on a same metal layer. For example, both are located on the third mounting metal layer 3233, or both are located on the first mounting metal layer 3231, or both are located on the second mounting metal layer 3232. In this application, it is not required that the second metal brazed substrate 37 for connecting the thermistor 383 be disposed on the third mounting metal layer 3233. In another implementation, both the chip 330 and the second metal brazed substrate 37 for connecting the thermistor 383 are disposed on another metal layer according to a design requirement for the power module 30.

The thermistor 383 may be welded to the first substrate electrode 375 and the second substrate electrode 377 through a solder.

The second metal brazed substrate 37 may be welded to a surface, away from the first insulation substrate 321, of the mounting metal layer 323 through a solder.

In this implementation, the first metal brazed substrate 32 is one of an active metal welded substrate and an insulation metal substrate, and the second metal brazed substrate 37 is a copper-clad ceramic substrate.

In some implementations, the metal layer on the second metal brazed substrate 37 may serve as a signal wire. This helps improve flexibility of line distribution in the power module 30. Some lines may be prepared by using a metal layer on the first metal brazed substrate 32, and some lines may be prepared by using a metal layer on the second metal brazed substrate 37, so that line distribution is more flexible.

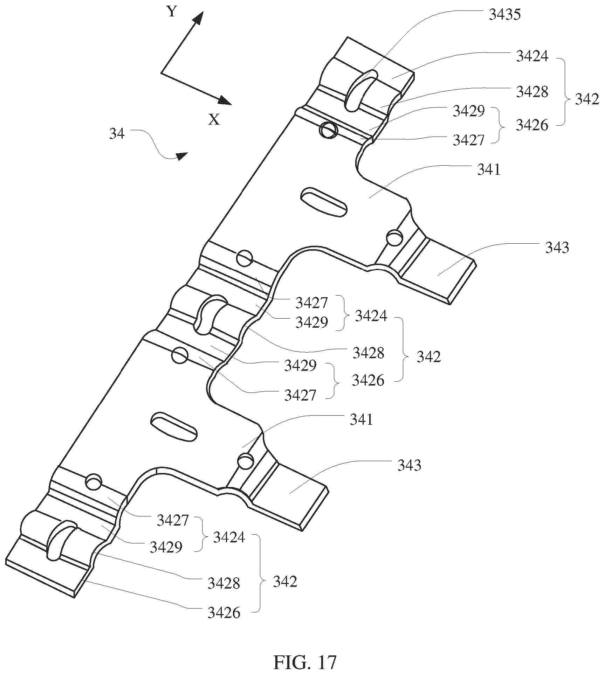

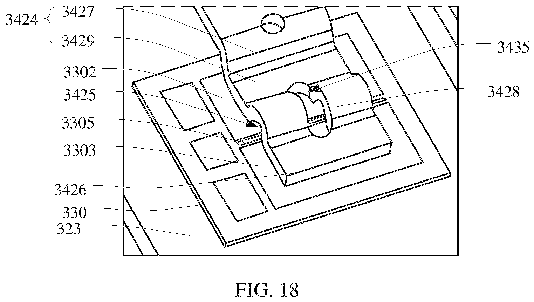

In a possible implementation, FIG. 17 is a three-dimensional diagram of a clip according to an embodiment of this application, and FIG. 18 is a diagram of connection between a chip and a part of a clip according to an embodiment of this application. Bodies 341 and connecting units 342 are alternately disposed along a first direction, and one body 341 is connected between every two connecting units 342. In this way, widths of the bodies 341 along a third direction can be reduced, and manufacturing costs of the clip 34 are reduced. Along the first direction, a first contact portion 3424 of a connecting unit 342 at a first end of the clip 34 is fastened to an adjacent body 341, a second contact portion 3426 of a connecting unit 342 at a second end of the clip 34 is fastened to an adjacent body 341, and both a first contact portion 3424 and a second contact portion 3426 of a connecting unit 342 at a non-end position on the clip 34 are fastened to bodies 341. The first contact portion 3424 is in contact with and electrically connected to a first source 3302, and the second contact portion 3426 is in contact with and electrically connected to a second source 3303.

The connecting unit 342 further includes a bent portion 3428. The bent portion 3428 is connected between the first contact portion 3424 and the second contact portion 3426 along the first direction. The bent portion 3428 protrudes along a direction away from a first insulation substrate 321. The first contact portion 3424, the bent portion 3428, and the second contact portion 3426 enclose an avoidance space 3425. The avoidance space 3425 and a gate wire 3305 are arranged along a second direction. The avoidance space 3425 has an avoidance opening arranged toward a corresponding chip 330, so that a gap is formed between the bent portion 3428 and the corresponding chip 330, and the bent portion 3428 is not in contact with a gate wire 3305 of the chip 330. The first contact portion 3424 is fastened to the second contact portion 3426 through the bent portion 3428. This helps enhance strength of the clip 34. The bent portion 3428 is provided with a buffer hole 3435 that passes through the bent portion 3428 along the second direction. The buffer hole 3435 is configured to reduce and buffer stress applied by the clip 34 to the chip 330. This helps reduce a possibility that the chip 330 is damaged due to the stress applied by the clip 34, and extends cycle life of the power module 30. The buffer hole 3435 may be a through hole that passes through the bent portion 3428 along the second direction. The buffer hole 3435 may alternatively not be a through hole. The buffer hole 3435 may be in a circular shape, a square shape, or the like. A shape of the buffer hole 3435 is not limited in this application.

A design with three power pins is used in the power module 30 provided in this application, sources (including first sources 3302 and second sources 3303) on front surfaces, away from the first metal brazed substrate 32, of chips 330 are connected through the clip (clip) 34 to implement interconnection between a plurality of chips 330, and no built-in gate resistor is used, or a quantity of used gate resistors is less than a quantity of parallel chips. In this way, higher electrical performance is achieved.

A solution with single-sided direct cooling, with chips sintered on the first metal brazed substrate (AMB) 32 by using silver, with sources of parallel chips 330 connected to metal layers on the first metal brazed substrate 32 through the clip 34, and with the second metal brazed substrate (DBC) 37 is used for the power module 30 provided in this application, to further improve power density and reliability of the power module 30.

This application provides the design with three power pins and the design with a plurality of chips connected to the clip in parallel. This significantly reduces parasitic inductance and switching loss of the power loop, and significantly improves a current equalization characteristic of the power loop.

This application provides the clip design for the power module 30. This can improve dynamic current equalization, avoid a risk of high-frequency oscillation during a switching process or under a short-circuit working condition at a high voltage and a large current, extend power cycle life of the power module 30, increase a bonding surface area between the clip 34 and the plastic package body 35, and reduce a possibility of delamination of a plastic package.

A design with no gate resistor 381 or with built-in gate resistors 381 fewer than parallel chips is used. This reduces a quantity of components in the package, and therefore reduces a rate of module failure caused by potential component failure, saves layout space on the first metal brazed substrate (AMB), and simplifies a packaging process.

The second metal brazed substrate 37 with a small area can be used for leading out the thermistor 383 and the gate resistor 381 and arranging jumpers of a signal loop. This greatly saves layout space on the first metal brazed substrate, resolves a problem that such small surface mount devices (Surface Mounted Devices, SMD) on the first metal brazed substrate (AMB) 32 with thick copper cannot be directly welded, and ensures reliability of the SMD devices.

A power bar of power pins is bent. This can effectively reduce a force applied to a plastic package body during application of a module, and improve reliability of the module.

A module with a heat sink is plastic-packaged after being sintered or welded to improve reliability of the module. This application provides a highly reliable plastic-packaged module with strong heat dissipation and high power density, and a manufacturing solution.

It should be understood that expressions such as "include" and "may include" that may be used in this application indicate existence of a disclosed function, operation, or constituent element, and are not limited to one or more additional functions, operations, or constituent elements. In this application, terms such as "include" and/or "have" may be construed as indicating a particular feature, quantity, operation, constituent element, component, or a combination thereof, but shall not be construed as excluding existence or possible addition of one or more other features, quantities, operations, constituent elements, components, or combinations thereof.

In addition, in this application, the expression "and/or" includes any and all combinations of terms listed in association. For example, the expression "A and/or B" may include A, may include B, or may include both A and B.

In this application, expressions including ordinal numbers such as "first" and "second" may modify elements. However, such elements are not limited by the expressions. For example, the expressions do not limit an order and/or importance of the elements. The expressions are used only to distinguish one element from another. For example, first user equipment and second user equipment indicate different user equipment, although both the first user equipment and the second user equipment are user equipment. Similarly, without departing from the scope of this application, a first element may be referred to as a second element, and similarly, a second element may also be referred to as a first element.

When a component is referred to as "being connected to" or "accessing" another component, it should be understood that the component may be directly connected to or access the another component, or there may be another component between the component and the another component. In addition, when a component is referred to as "being directly connected to" or "directly accessing" another component, it should be understood that there is no component between the component and the another component.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises:
a first metal brazed substrate;
a chipset disposed on the first metal brazed substrate, wherein the chipset comprises at least two chips arranged in a straight line along a first direction, and the first direction is parallel to a plane on which a side, away from the first metal brazed substrate, of the chips is located; and
a clip, wherein the clip covers a side, away from the first metal brazed substrate, of the chipset, the clip comprises a body, at least two connecting units, and at least one connecting arm, each connecting unit is electrically connected to a corresponding chip, every two adjacent connecting units are connected along the first direction through the body, and the connecting arm is convexly disposed on the body, wherein
each connecting arm is arranged with respect to two adjacent chips in the chipset, the connecting arm is electrically connected to the first metal brazed substrate, a shortest distance between the connecting arm and one of the two adjacent chips is a first shortest distance, a shortest distance between the connecting arm and the other of the two adjacent chips in the chipset is a second shortest distance, and a difference between the first shortest distance and the second shortest distance is not greater than 30% of the first shortest distance.

2. The power module according to claim 1, wherein each chip comprises a first source and a second source that are arranged along the first direction, a first source of one of two adjacent chips in the chipset and a second source of the other chip are arranged adjacently, the connecting unit is electrically connected to a first source and a second source of a corresponding chip, and the connecting arm is convexly disposed on the body and bends and extends toward the first metal brazed substrate.

3. The power module according to claim 2, wherein each chip further comprises a gate wire, and the first source, the gate wire, and the second source are arranged along the first direction; and
each connecting unit further comprises a first contact portion, an avoidance space, and a second contact portion that are sequentially arranged along the first direction, the first contact portion is in contact with the first source, the second contact portion is in contact with the second source, the avoidance space has an avoidance opening arranged toward the gate wire, and a position of the avoidance opening is arranged with respect to a position of the gate wire.

4. The power module according to claim 3, wherein at least two connecting holes are formed on the body, each connecting unit corresponds to one connecting hole, the first contact portion is connected to a corresponding hole wall of the connecting hole, and the second contact portion is connected to a corresponding hole wall of the connecting hole.

5. The power module according to claim 3 or 4, wherein the body and the first metal brazed substrate are spaced apart, and at least one of the first contact portion and the second contact portion in each connecting unit is connected to the body; and
the first contact portion connected to the body and the second contact portion connected to the body each comprise a connecting section and a contact section, at least a part of the connecting section bends relative to the body, the connecting section is connected between the body and the contact section, a contact section of the first contact portion is in contact with a corresponding first source, and a contact section of the second contact portion is in contact with a corresponding second source.

6. The power module according to claim 5, wherein the power module further comprises a plastic package body, and the plastic package body is wrapped around the first metal brazed substrate, the chipset, and the clip; and
a first locking hole is provided at a joint between the connecting section and the body, and the first locking hole is filled with the plastic package body.

7. The power module according to any one of claims 2 to 5, wherein the power module further comprises a plastic package body, the plastic package body is wrapped around the first metal brazed substrate, the chipset, and the clip, the body is provided with a second locking hole, and the second locking hole is filled with the plastic package body.

8. The power module according to any one of claims 3 to 7, wherein a first contact portion and a second contact portion in at least one connecting unit are arranged at a spacing along the first direction, the avoidance space is a groove that passes through the clip along a second direction, and the second direction is perpendicular to the plane on which the side, away from the first metal brazed substrate, of the chips is located.

9. The power module according to any one of claims 2 to 8, wherein the at least one connecting unit further comprises a bent portion, the bent portion is connected between the first contact portion and the second contact portion along the first direction, the bent portion protrudes along a direction away from the first metal brazed substrate, and the first contact portion, the bent portion, and the second contact portion enclose the avoidance space.

10. The power module according to claim 9, wherein the bent portion is provided with a buffer hole that passes through the bent portion along the second direction.

11. The power module according to any one of claims 2 to 10, wherein the first metal brazed substrate comprises a first insulation substrate and a mounting metal layer covering the first insulation substrate, and the chipset is disposed on a side, away from the first insulation substrate, of the mounting metal layer; and
there are a plurality of mounting metal layers, the plurality of mounting metal layers are arranged on the first insulation substrate at spacings, the plurality of mounting metal layers comprise a first mounting metal layer, a second mounting metal layer, a third mounting metal layer, and a fourth mounting metal layer, the second mounting metal layer comprises a first extension portion, a groove, and a second extension portion, an end of the first extension portion is connected to an end of the second extension portion, the first mounting metal layer, the first extension portion, the groove, the second extension portion, and the third mounting metal layer are sequentially arranged along a third direction, at least a part of the fourth mounting metal layer is located in the groove, the third direction is parallel to the plane on which the side, away from the first metal brazed substrate, of the chips is located, and the third direction is perpendicular to the first direction.

12. The power module according to claim 11, wherein the power module further comprises an input terminal and an output terminal, and the input terminal and the output terminal are located at two opposite ends of the first metal brazed substrate along the first direction; and
the power module is a half-bridge power module, the input terminal comprises a first positive power pin, a second positive power pin, and a third negative power pin, the first positive power pin is electrically connected to the first mounting metal layer, the second positive power pin is electrically connected to the third mounting metal layer, the third negative power pin is electrically connected to the fourth mounting metal layer, and the output terminal is electrically connected to the second mounting metal layer.

13. The power module according to claim 12, wherein a plurality of chipsets comprise a first chipset, a second chipset, a third chipset, and a fourth chipset, the first chipset is located on the first mounting metal layer, the second chipset is located on the second mounting metal layer, the third chipset is located on the third mounting metal layer, and the fourth chipset is located on the second extension portion; and
a connecting arm on the first chipset is electrically connected to the first extension portion, a connecting arm on the second chipset is electrically connected to the fourth mounting metal layer, a connecting arm on the third chipset is electrically connected to the second extension portion, and a connecting arm on the fourth chipset is electrically connected to the fourth mounting metal layer.

14. The power module according to any one of claims 1 to 13, wherein the power module further comprises a second metal brazed substrate and an electronic component, the second metal brazed substrate is located on the first metal brazed substrate, and the electronic component is located on a side, away from the first metal brazed substrate, of the second metal brazed substrate, and is electrically connected to the second metal brazed substrate.

15. A power conversion apparatus, comprising a circuit board and the power module according to any one of claims 1 to 14, wherein the power module is disposed on the circuit board.
